# EUROPEAN PATENT APPLICATION

(11) **EP 4 831 064 A1**
(43) Date of publication of application: **28.10.2026**
(21) Application number: 26158641.6
(22) Date of filing: 13.02.2026
(51) Int. Cl.: B64D 37/02

(54) **COMPUTING SYSTEM, COMPUTER-IMPLMENTED METHOD, AND AIRCRAFT USING MACHINE LEARNING-BASED FUEL QUANTITY INDICATION SYSTEM FOR AN AIRCRAFT**

(30) Priority: 26.02.2025 US 202519064538
(71) Applicant: The Boeing Company, Arlington, VA 22202 (US)
(72) Inventor: FIALHO, Gustavo Coelho, ARLINGTON, 22202 (US); WILCOXSON, P. Chace, ARLINGTON, 22202 (US); NISHI, Erica Yuri, ARLINGTON, 22202 (US); BELLONI MOURAO, Carlos Henrique, ARLINGTON, 22202 (US); COWDER, Shawn Michael, ARLINGTON, 22202 (US)
(74) Representative: Plasseraud IP

(57) **Abstract**

Examples are disclosed that relate to a machine learning-based approach for determining a quantity of fuel available in an aircraft with enhanced accuracy under normal and abnormal operating conditions. In one example, fuel data is received from a plurality of fuel sensor probes distributed throughout the aircraft. Flight data is received from a plurality of flight sensors of the aircraft. A machine learning model is configured to receive the fuel data and the flight data as input and output a fuel quantity measurement based at least on the fuel data and the flight data. The machine learning model is trained using synthetic training data that is generated by a computer simulation environment program that is configured to model operation of the aircraft during a range of environmental conditions.

## Description

### FIELD

The present disclosure relates generally to determining a quantity of fuel available in fuel tank(s) of an aircraft, and in particular, using a machine learning model that is trained to determine a quantity of fuel available in the fuel tank(s) of the aircraft.

### BACKGROUND

A fuel quantity indication system (FQIS) in an aircraft is designed to measure, monitor, and display the amount of fuel available in fuel tank(s) of the aircraft. The FQIS provides real-time fuel quantity information to pilots and onboard systems of the aircraft to ensure dependable and efficient operation of the aircraft. A conventional FQIS primarily relies on software that uses linear regression models to interpret fuel sensor probe data samples and fit the distribution of data samples to a polynomial curve that estimates the fuel quantity measurement. The estimation of the fuel quantity measurement using the linear regression models is susceptible to inaccuracy due to a wide range of operational parameters (e.g., gravity, acceleration, pitch and roll angles) that affect the fuel level in the fuel tanks.

Furthermore, conventional FQIS software typically includes explicit programming codes that have notable issues. One major issue is the complexity and difficulty involved in creating equations to compensate for abnormal operating conditions, such as potential scenarios in which a component of the FQIS fails / degrades. More particularly, developers are required to specify correction factors/functions for each potential failure scenario and determine how the equations determining the fuel quantity should be adjusted using the correction factors/functions that are based on the condition of the failed / degraded component of the FQIS in the corresponding failure scenario. This development process can be time-consuming, error-prone, and challenging to maintain as new failure scenarios arise. Furthermore, conventional software often fails to handle combinations of failures / degradations, resulting in overall FQIS failure and/or the FQIS providing inaccurate fuel quantity information to the pilots and onboard systems of the aircraft.

Such issues adversely affect the capacity of the conventional FQIS to provide reliable and accurate fuel quantity information under both normal and abnormal operating conditions, and more particularly in scenarios where the FQIS suffers one or more failures / degradations.

### SUMMARY

This disclosure relates to computing systems, computer-implemented methods, and aircrafts as per the amended claims. Examples are disclosed that relate to a machine learning-based approach for determining a quantity of fuel available in fuel tank(s) of an aircraft with enhanced accuracy under normal and abnormal operating conditions. In one example, fuel data is received from a plurality of fuel sensor probes distributed throughout one or more fuel tanks of an aircraft. The fuel data indicates fuel levels measured by the plurality of fuel sensor probes. Flight data is received from a plurality of flight sensors of the aircraft. The flight data indicates a set of values for a plurality of operating parameters of the aircraft. A machine learning model is executed. The machine learning model is configured to receive the fuel data and the flight data as input and output a fuel quantity measurement of the aircraft based at least on the fuel data and the flight data. The machine learning model is trained using synthetic training data that is generated by a computer simulation environment program that is configured to model operation of the aircraft during a range of environmental conditions. The range of environmental conditions are characterized by simulation input data that indicates a set of values for a plurality of simulated operating parameters of the aircraft during the range of environmental conditions. The fuel quantity measurement of the aircraft is output.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

### BRIEF DESCRIPTION OF THE DRAWINGS

FIG. 1 shows an example aircraft in which a machine learning-based approach for determining a quantity of fuel available in fuel tanks of the aircraft is implemented, according to one embodiment of the present disclosure.
FIG. 2 schematically shows a fuel quantity indication system (FQIS) in which a machine learning-based approach for determining a quantity of fuel available in fuel tank(s) of an aircraft is implemented, according to one embodiment of the present disclosure.
FIG. 3 schematically shows example flight data that are used as input to a machine learning model to determine a quantity of fuel available in fuel tank(s) of an aircraft, according to one embodiment of the present disclosure.
FIG. 4 schematically shows example simulation input data that is used to model operation of an aircraft during a range of environmental conditions in a computer simulation environment program in order to generate synthetic training data that is used to train a machine learning model to determine a quantity of fuel available in fuel tank(s) of an aircraft, according to one embodiment of the present disclosure.
FIG. 5 schematically shows an example process for training a machine learning model to determine a quantity of fuel available in fuel tank(s) of an aircraft, according to one embodiment of the present disclosure.
FIG. 6 shows an example computer-implemented method for determining a quantity of fuel available in fuel tank(s) of an aircraft using a machine learning model, according to one embodiment of the present disclosure.
FIG. 7 schematically shows an example computing system that is representative of any of the computing systems in the computing environment shown in FIG. 2.

### DETAILED DESCRIPTION

A conventional fuel quantity indication system (FQIS) in an aircraft relies on software that includes explicit programming codes that have notable issues. One major issue is the complexity and difficulty involved in creating equations to compensate for abnormal operating conditions. This development process can be time-consuming, error-prone, and challenging to maintain as new failure scenarios arise. Furthermore, conventional software often fails to handle combinations of failures / degradations, resulting in overall FQIS failure and/or the FQIS providing inaccurate fuel quantity information to the pilots and onboard systems of the aircraft. Such issues adversely affect the capacity of the conventional FQIS to provide reliable and accurate fuel quantity information under both normal and abnormal operating conditions, and more particularly in scenarios where the FQIS suffers one or more failures / degradations.

Accordingly, to address these and other issues discussed herein, examples are disclosed that relate to a machine learning-based approach for determining a quantity of fuel available in fuel tank(s) of an aircraft with enhanced accuracy under normal and abnormal operating conditions. In one example, fuel data is received from a plurality of fuel sensor probes distributed throughout one or more fuel tanks of an aircraft. The fuel data indicates fuel levels measured by the plurality of fuel sensor probes. Flight data is received from a plurality of flight sensors of the aircraft. The flight data indicates a set of values for a plurality of operating parameters of the aircraft. A machine learning model is executed. The machine learning model is configured to receive the fuel data and the flight data as input and output a fuel quantity measurement of the aircraft based at least on the fuel data and the flight data. The machine learning model is trained using synthetic training data that is generated by a computer simulation environment program that is configured to model operation of the aircraft during a range of environmental conditions. The range of environmental conditions are characterized by simulation input data that indicates a set of values for a plurality of simulated operating parameters of the aircraft during the range of environmental conditions. The fuel quantity measurement of the aircraft is output.

The machine learning-based approach for determining the quantity of fuel available in fuel tank(s) of an aircraft effectively addresses many issues with conventional FQIS. As one example, the machine learning-based approach significantly enhances the accuracy of fuel quantity measurements relative to the convention FQIS without the need for additional components, resulting in improved fuel management and overall operational effectiveness. As another example, the machine learning-based approach is fault tolerant, ensuring functionality even during abnormal operation, such as when components of the FQIS become degraded / fail. Such resilience enhances reliability and performance during degraded operation, allowing for increased payload capacity and improved rate of dispatch for the aircraft. By reducing errors and minimizing downtime caused by failures, the machine learning-based approach offers substantial benefits in terms of operational efficiency and cost-effectiveness relative to conventional FQIS.

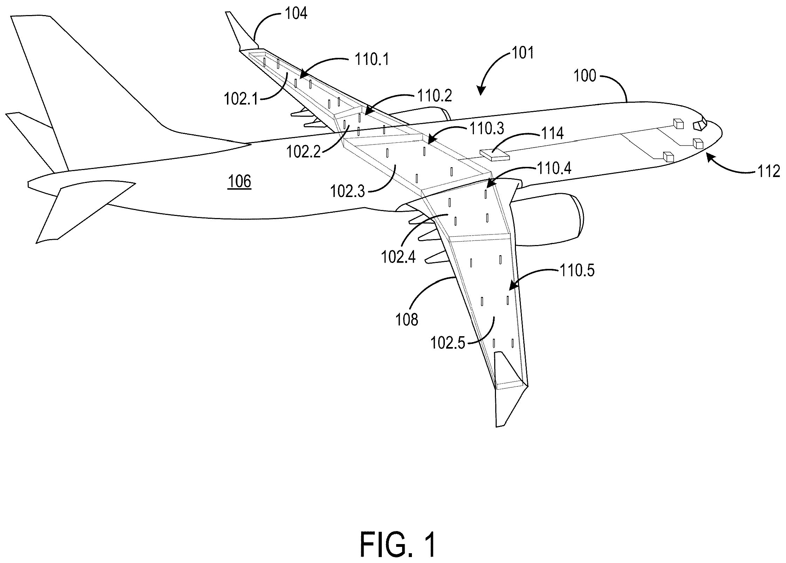

FIG. 1 shows an example aircraft 100 in which a machine learning-based approach for determining a quantity of fuel available in fuel tanks 102 of the aircraft 100 is implemented. The aircraft 100 comprises a FQIS 101 including a plurality of fuel tanks 102 (e.g., 102.1, 102.2, 102.3, 102.4, 102.5) that are distributed throughout the aircraft 100. In particular, a first fuel tank 102.1 is located in an outer region of a first wing 104 of the aircraft 100, a second fuel tank 102.2 is located in an inner region of the first wing 104, a third fuel tank 102.3 is locate in a fuselage 106 of the aircraft 100, a fourth fuel tank 102.4 is located in an inner region of a second wing 108 of the aircraft, and a fifth fuel tank 102.5 is located in an outer region of the second wing 108. In other embodiments, the aircraft 100 may comprise a different arrangement of fuel tanks 102. In some embodiments, an aircraft may include a single fuel tank.

The FQIS 101 includes a plurality of fuel sensor probes 110 that are distributed throughout the plurality of fuel tanks 102 of the aircraft 100. In particular, a first subset of fuel sensor probes 110.1 are distributed throughout the first fuel tank 102.1, a second subset of fuel sensor probes 110.2 are distributed throughout the second fuel tank 102.2, a third subset of fuel sensor probes 110.3 are distributed throughout the third fuel tank 102.3, a fourth subset of fuel sensor probes 110.4 are distributed throughout the fourth fuel tank 102.4, and a fifth subset of fuel sensor probes 110.5 are distributed throughout the fifth fuel tank 102.5. The first, second, third, fourth, and fifth subsets of fuel sensor probes 110.1, 110.2, 110.3, 110.4, 110. 5 collectively correspond to the plurality of fuel sensor probes 110.

In one example, the plurality of fuel sensor probes 110 are capacitive fuel sensor probes that operate based on a dielectric constant difference between fuel and air. A wet length of the probe changes as fuel levels fluctuate, altering capacitance, and providing a fuel quantity reading. In other examples, the plurality of fuel sensor probes 110 may comprise another type of fuel sensor probe.

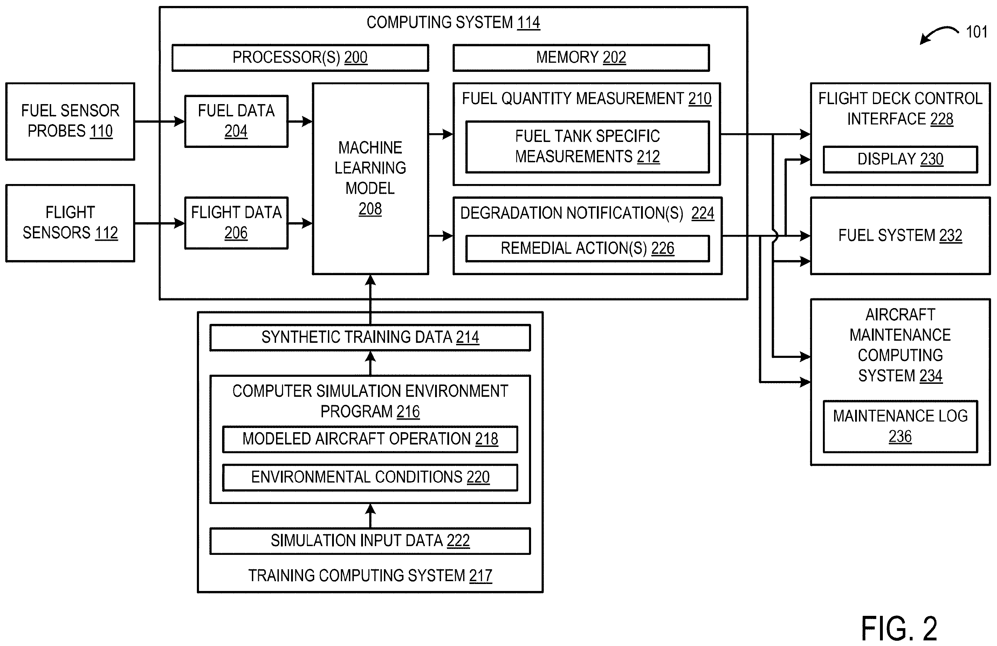

Each of the plurality of fuel sensor probes 110 is configured to output fuel data 204 (shown in FIG. 2) indicating a fuel level measured by the corresponding fuel sensor probe. Any suitable number of fuel sensor probes 110 can be distributed throughout the plurality of fuel tanks 102 to accurately measure the fuel levels in the plurality of fuel tanks 102. In some embodiments, the number of fuel sensor probes and the placement of fuel sensor probes within a given fuel tank is dependent on the geometry of the given fuel tank. For example, fuel sensor probes can be positioned in different low points and high points of the fuel tank in order to accurately capture the actual fuel level at these different points within the fuel tank.

The FQIS 101 communicates with a plurality of flight sensors 112 that are configured to output flight data 206 (shown in FIGS. 2-3) indicating a set of values for a plurality of operating parameters of the aircraft 100. These operating parameters of the aircraft 100 affect fuel levels within the plurality of fuel tanks 102 during operation of the aircraft 100. In one example, the plurality of flight sensors 112 include one or more gyroscopes that are configured to measure pitch, roll, and yaw angles of the aircraft 100 and one or more accelerometers that are configured to measure longitudinal axis acceleration and vertical axis acceleration of the aircraft 100. In other examples, the FQIS 101 can include other sensors that are configured to measure other operating parameters of the aircraft 100.

The FQIS 101 includes a computing system 114 that is configured to control operation of the FQIS 101. The computing system 114 is connected to the plurality of fuel sensor probes 110 and the plurality of flight sensors 112. The computing system 114 is configured to receive the fuel data 204 from the plurality of fuel sensor probes 110 and receive the flight data 206 from the plurality of flight sensors 112. The computing system 114 is configured to execute a machine learning model 208 (shown in FIG. 2) that is configured to receive the fuel data 204 and the flight data 206 as input and output a fuel quantity measurement 210 of the aircraft 100 based at least on the fuel data 204 and the flight data 206. By taking into account the flight data 206 of the aircraft 100 in conjunction with the fuel data 204, the machine learning model 208 can compensate for effects seen by the aircraft 100 that influence the fuel level in the fuel tanks 102, and correspondingly accounting for those effects in the measurements of the fuel sensor probes 110 to accurately determine the quantity of fuel in the aircraft 100.

The fuel quantity measurement 210 generated by the machine learning model 208 can be output to various systems on the aircraft 100. In one example, the fuel quantity measurement 210 is output to a display 230 of a flight deck control interface 228 (shown in FIG. 2). The fuel quantity measurement is thus displayed on the display 230, so that pilots and crew of the aircraft 100 can be informed of the fuel quantity measurement 210 of the aircraft 100 and control operation of the aircraft 100 based at least on the fuel quantity measurement 210.

The flight deck control interface 228 may comprise, additionally to the display 230, one or more input interfaces such as for example a keyboard, buttons, joystick, tactile screens etc. Such one or more input interfaces may allow pilots to enter flight instructions to control the aircraft. Flight instructions may belong to many different types. For example, flight instructions may consist in a new flight plan, a modification of the existing flight plan, a modification of the speed of the aircraft, manual commands, etc. Subsequently to said output to the display 230 of the flight deck control interface 228, one or more flight instructions can be received by the one or more input interfaces, and the aircraft can be controlled according to said received one or more instructions. Thus, the pilots can, after having been informed of the fuel quantity, control the aircraft according to the available fuel quantity.

In some embodiments, control of the aircraft 100 can be automatically adjusted based at least on the fuel quantity measurement 210. In one example, a flight plan can be dynamically adjusted during a flight of the aircraft 100 based at least on the fuel quantity measurement 210. For example, the computing system 114 can be configured to automatically adjust a flight plan of the aircraft 100 dynamically in mid-flight to specify that that aircraft 100 take a more direct route to a destination based at least on the fuel quantity measurement 210 indicating the fuel level is lower than a threshold (or based at least on some other fuel consumption metric). As another example, the computing system 114 can be configured to automatically adjust the flight plan of the aircraft 100 dynamically in mid-flight to specify that aircraft 100 take a more circuitous route to a destination based at least on the fuel quantity measurement 210 indicating the fuel level is greater than the threshold. For example, the aircraft 100 could take the more circuitous route to avoid turbulent air space, such as due to a storm or other similar weather conditions.

In some embodiments, the machine learning model 208 is configured to identify that one or more fuel sensor probes of the plurality of fuel sensor probes 110 is degraded based at least on the fuel data 204 and the flight data 206. Further, the machine learning model 208 is configured to compensate for degradation of the fuel sensor probe(s) and corresponding abnormal fuel level measurements produced by the degraded fuel sensor probe(s) in the calculation of the fuel quantity measurement 210. Further, in some embodiments, the machine learning model 208 is configured to output a degradation notification 224 (shown in FIG. 2) indicating the fuel sensor probe(s) are identified as being degraded. In one example, the degradation notification 224 can be displayed, via the display 230 of the flight deck control interface 228 to inform the pilot(s) and/or crew of the degraded fuel sensor probe(s).

In some embodiments, the computing system 114 is configured to output the fuel quantity measurement 210 to an aircraft maintenance computing system 234 to be stored in a maintenance log 236. Fuel quantity measurements 210 generated throughout operation of the aircraft 100 can be stored in the maintenance log 236 and used as a reference to track functionality of the FQIS 101 over the operational lifespan of the aircraft 100.

In some embodiments, the computing system 114 is configured to output the degradation notification(s) 224 to the aircraft maintenance computing system 234 to be stored in the maintenance log 236. The degradation notification(s) 224 stored in the maintenance log 236 provide a maintenance crew with precise information about failure or degradation of components of the FQIS 101, so that the maintenance crew can appropriately address the identified issues in a timely manner with a scheduled maintenance operation.

In some embodiments, the degradation notification 224 includes one or more remedial actions 226 (shown in FIG. 2) to be performed by the FQIS in an automated manner to compensate for the fuel sensor probe(s) being degraded. In one example, the remedial action(s) 226 include disabling the fuel sensor probe(s) identified as being degraded from being used to generate the fuel quantity measurement 210. In other examples, other remedial actions can be taken by the FQIS 101 to maintain the accuracy of the fuel quantity measurement 210 during abnormal operating conditions. In some embodiments, the remedial action(s) 226 include sending the degradation notification(s) 224 to the aircraft maintenance computing system 234 to be stored in the maintenance log 236 and/or sending the degradation notification 224 to a computing device associated with the maintenance crew, so that the maintenance crew can schedule a maintenance operation to address the issue in a timely manner.

The FQIS 101 of the aircraft 100 is provided as a non-limiting example of a system that employs the machine learning-based approach for determining a quantity of fuel available in fuel tanks of an aircraft. In other examples, the machine learning-based approach can be employed in an FQIS in other types of aircraft.

FIG. 2 schematically shows the FQIS 101 in which a machine learning-based approach for determining a quantity of fuel available in the fuel tanks 102 of the aircraft 100 is implemented, according to one embodiment of the present disclosure. The computing system 114 comprises one or more processor(s) 200 configured to execute instructions stored in memory 202 to perform computing operations related to determining the quantity of fuel available in the fuel tanks 102 of the aircraft 100 and other computing operations related to operation of the FQIS 101 during normal and abnormal operating conditions.

In one example, the processor(s) 200 are configured to execute instructions stored in the memory 202 to receive fuel data 204 from the plurality of fuel sensor probes 110 (shown in FIG. 1). The fuel data 204 represents fuel levels measured by each of the plurality of fuel sensor probes 110 distributed throughout the plurality of fuel tanks 102 of the aircraft 100 (shown in FIG. 1).

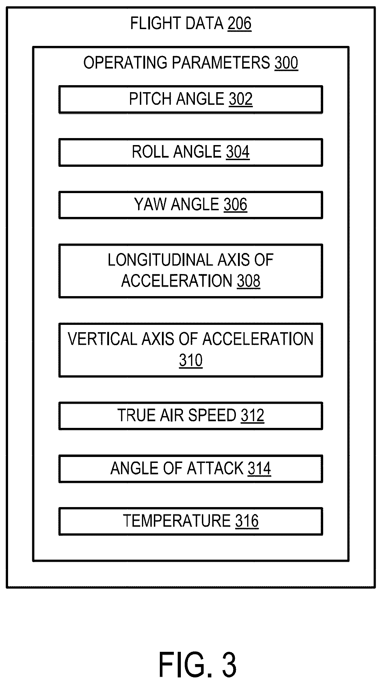

Further, the processor(s) 200 are configured to execute instructions stored in the memory 202 to receive flight data 206 from a plurality of flight sensors 112 of the aircraft 100. FIG. 3 schematically shows example flight data 206, according to one embodiment of the present disclosure. The flight data 206 indicates a set of values for a plurality of operating parameters 300 of the aircraft 100 that are output by the plurality of flight sensors 112. In the illustrated example, the plurality of operating parameters 300 include a pitch angle 302, a roll angle 304, a yaw angle 306, longitudinal axis of acceleration 308, vertical axis of acceleration 310, a true air speed 312, an angle of attack 314, and a temperature 316. The pitch angle 302, the roll angle 304, and the yaw angle 306 can be output from one or more gyroscopes. The longitudinal axis of acceleration 308 and vertical axis of acceleration 310 can be output from one or more accelerometers. The true air speed 312 is the actual speed of the aircraft 100 relative to the undisturbed air mass through which it is flying. The true air speed 312 accounts for altitude and air density, making it a more accurate measure of an aircraft's speed in flight compared to an indicated airspeed (IAS). The angle of attack 314 can be output from an angle-of-attack sensor. The temperature 316 can be output from one or more temperature sensors. In some embodiments, the temperature 316 includes a plurality of temperature measurements output by a plurality of temperature sensors that are strategically positioned to monitor temperature variations across different aircraft components. The plurality of operating parameters 300 are selected based at least on having an effect on the fuel that is measured by the plurality of fuel sensor probes 110 due to dynamic conditions that occur during flight of the aircraft 100.

Returning to FIG. 2, the processor(s) 200 are configured to execute instructions stored in the memory 202 to execute a machine learning model 208 that is configured to receive the fuel data 204 and the flight data 206 as input and output a fuel quantity measurement 210 of the aircraft 100 based at least on the fuel data 204 and the flight data 206. The fuel quantity measurement 210 indicates a real-time snapshot of a current total fuel quantity available on-board the aircraft 100.

In some embodiments where the aircraft 100 includes a plurality of fuel tanks 102, the fuel quantity measurement 210 further includes a plurality of tank-specific fuel quantity measurements 212 corresponding to the plurality of fuel tanks 102 of the aircraft 100.

The machine learning model 208 can be implemented using different types of machine learning models depending on the embodiment. In one example, the machine learning model 208 is implemented as a linear regression machine learning model. In another example, the machine learning model 208 is implemented as a boosted random forest machine learning model, such as XGBoost. In yet another example, the machine learning model 208 is implemented as a neural network, such as a convolutional neural network (CNN). In yet another example, the machine learning model 208 is implemented using deep learning techniques that include neural networks with multiple layers to automatically learn features and/or patterns between data points.

Obtaining a significantly large set of training data to train the machine learning model 208 can be difficult if merely relying on training data generated from actual operation of aircraft, because there are not many scenarios where an aircraft operates under abnormal conditions where fuel sensor probe(s) become degraded / fail and produce abnormal fuel level measurements that can be tracked and tabulated for use as training data. To address the issue of the lack of actual real-world training data that is available for the machine learning model 208, the machine learning model 208 is trained using synthetic training data 214 that is generated by a computer simulation environment program 216 executed by a training computing system 217.

The computer simulation environment program 216 is configured to model operation 218 of the aircraft 100 during a range of environmental conditions 220. For example, the computer simulation environment program 216 can simulate different flights taken by the aircraft 100 (or more granularly, the aircraft 100 can perform various maneuvers within a given flight) that can affect the fuel quantity measurements. The aircraft 100 can be modeled to have different quantities of fuel and different payloads that can affect the fuel quantity measurements. Further, the computer simulation environment program 216 can simulate the flights of the aircraft 100 taken during different weather conditions that can affect the fuel quantity measurements. In some examples, the computer simulation environment program 216 is configured to model normal operation of the aircraft 100 where the fuel sensor probes 110 and the flight sensors 112 are functioning normally. Further, in some examples, the computer simulation environment program 216 is configured to model abnormal operation of the aircraft 100 where at least one of the fuel sensor probes 110 and/or the flight sensors 112 are degraded / fail. Moreover, in some examples, the computer simulation environment program 216 is configured to model abnormal operation of the aircraft 100 where multiple fuel sensor probes 110 and/or the flight sensors 112 are degraded / fail. The computer simulation environment program 216 is configured to model any suitable operation 218 of the aircraft 100 during any suitable range of environmental conditions 220 based at least on the simulation input data 222.

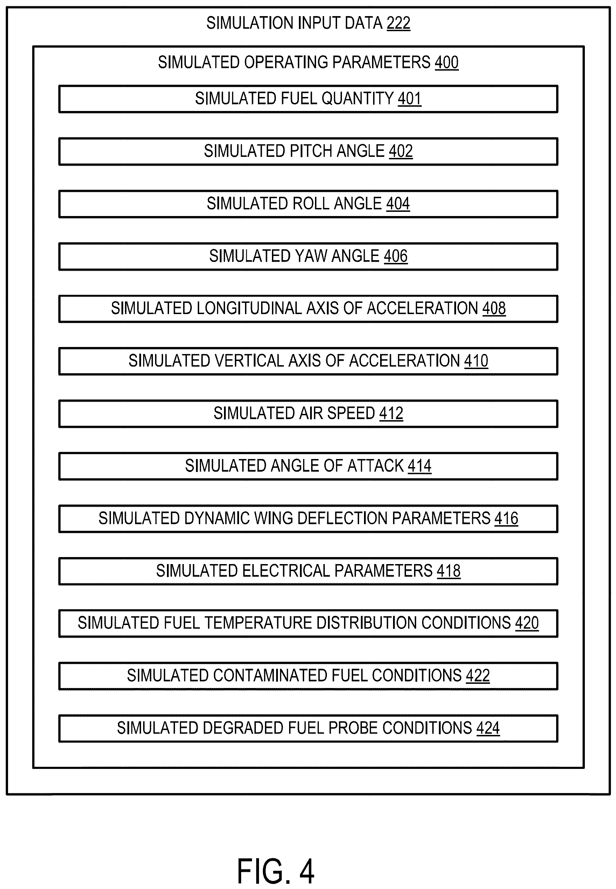

The range of environmental conditions 220 is characterized by simulation input data 222. FIG. 4 schematically shows example simulation input data 222 that the computer simulation environment program 216 uses to model operation 218 of an aircraft during the range of environmental conditions 220 and thereby generate the synthetic training data 214, according to one embodiment of the present disclosure. The machine learning model 208 is trained using the synthetic training data 214 in order to accurately determine the fuel quantity measurement 210 of the aircraft 100 during normal and abnormal operating conditions.

The range of environmental conditions 220 are characterized by the simulation input data 222 that indicates a set of values for a plurality of simulated operating parameters 400 of the aircraft 100 during the range of environmental conditions 220. The plurality of simulated operating parameters 400 can be adjusted by using sets of values of the parameters that correspond to different normal operating conditions of the aircraft 100. Further, the plurality of simulated operating parameters 400 can be adjusted by using sets of values of the parameters that correspond to different abnormal operating conditions of the aircraft 100.

In some embodiments, the plurality of simulated operating parameters 400 include operating parameters that affect the position and movement of the aircraft 100, and more particularly, the position / level of the fuel within the fuel tanks 102 of the aircraft. In particular, the operating parameters related to the position / movement of the fuel include a simulated fuel quantity 401 of fuel that resides in the fuel tanks of the aircraft 100, a simulated pitch angle 402, a simulated roll angle 404, a simulated yaw angle 406, a simulated longitudinal axis of acceleration 408, a simulated vertical axis of acceleration 410, a simulated true air speed 412, and a simulated angle of attack 414.

In some embodiments, the plurality of simulated operating parameters 400 further include simulated dynamic wing deflection parameters 416 that affect the shape of the wings 104, 108 of the aircraft 100, and correspondingly affect the shape of the fuel tanks 102.1, 102.2, 102.4, 102.5 positioned in the wings 104, 108.

In some embodiments, the plurality of simulated operating parameters 400 further include simulated electrical parameters 418 of the aircraft 100. The simulated electrical parameters 418 can induce electromagnetic effects in the wirings responsible for transmitting the fuel data 204 and the flight data 206 thereby affecting the fuel quantity measurement. Moreover, the simulated electrical parameters 418 can provide an indication of abnormal operation of the FQIS 101, such as via abnormal electrical signals output by fuel sensor probes 110 and/or the flight sensors 112.

In some embodiments, the plurality of simulated operating parameters 400 further includes simulated environmental conditions 420 that can lead to a fuel temperature distribution within the fuel tanks 102.1 to 102.5. The fuel temperature distribution affects the fuel's density locally and consequently impacts the fuel quantity measurement. In some embodiments, fuel data 204 include fuel temperature measurements which aid the determination of the fuel's density in support of total fuel quantity measurement 210. The machine learning model 208 can then improve its accuracy by learning to compensate for temperature readings in different operation scenarios.

In some embodiments, the plurality of simulated operating parameters 400 further include operating parameters that indicate abnormal operating conditions of the aircraft 100. More particularly, in some embodiments, the set of values of the plurality of simulated operating parameters 400 of the aircraft 100 indicated by the simulation input data 222 characterize simulated contaminated fuel conditions 422 of the aircraft 100 in which fuel in the fuel tanks 102 is contaminated and causes one or more fuel sensor probes of the plurality of fuel sensor probes 110 to output measurements of fuel levels that are abnormal for a designated simulated fuel quantity of the aircraft 100. In some embodiments, the set of values of the plurality of simulated operating parameters 400 of the aircraft 100 indicated by the simulation input data 222 characterize simulated degraded fuel probe conditions 424 of the aircraft in which one or more fuel sensor probes of the plurality of fuel sensor probes 110 is degraded and outputs measurements of fuel levels that are abnormal for a designated simulated fuel quantity of the aircraft 100.

These different sets of values of the simulated operating parameters 400 that characterize different abnormal operating conditions of the aircraft 100 provide training data that allows for the machine learning model 208 to be trained to recognize patterns in the input data (i.e., the fuel data 204 and the flight data 206) that enable the machine learning model 208 model to identify abnormal operating conditions and/or degraded components of the FQIS 101. Further, such training data allows for the machine learning model 208 to be trained to compensate for the identified abnormal operating conditions and/or degraded components of the FQIS 101 and corresponding abnormal fuel levels measurements in the calculation of the fuel quantity measurement 210 in order to provide accurate measurements even when the FQIS 101 is operating abnormally and/or has degraded components.

In other examples, other parameters can be included in the simulation input data 222 in order to generate the synthetic training data 214 used to train the machine learning model 208.

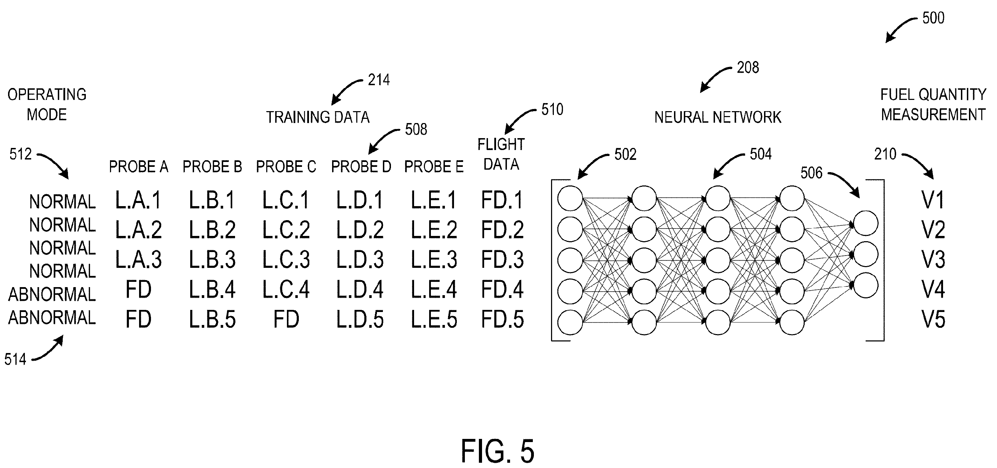

FIG. 5 schematically shows an example process 500 for training the machine learning model 208 to determine a quantity of fuel available in fuel tank(s) of an aircraft, according to one embodiment of the present disclosure. In the illustrated example, the machine learning model 208 is a neural network, such as a regression neural network. In one example, the neural network includes an input layer 502 that is configured to take in a feature set of data (e.g., the fuel data 204 and the flight data 206 shown in FIG. 2 at inference time once the neural network is trained). The input layer 502 is connected to shared hidden layers 504 that extract general features from the input data. The shared hidden layers 504 are connected to a task-specific output layer 506 that is configured to output one or more values corresponding to fuel quantity measurements 210 (e.g., total and/or tank-specific fuel quantity measurements).

The training process 500 includes providing the synthetic training data 214 to the neural network as input. The synthetic training data 214 includes specified synthetic wet length measurements 508 for the plurality of fuel sensor probes 110 and synthetic flight data 510 of the aircraft 100. More particularly, the synthetic training data 214 includes a first subset of training data 512 corresponding to normal operating conditions in which the specified synthetic wet length measurements 508 are accurate thereby indicating proper functionality of the plurality of fuel sensor probes 110. Further, the synthetic training data 214 includes a second subset of training data 514 corresponding to abnormal operating conditions in which the specified synthetic wet length measurements 508 include one or more measurements that are not accurate (e.g., FD: failed data) indicating that one or more fuel sensor probes is degraded / failed. In other examples, other parameters can be used to train the machine learning model 208 to recognize normal and abnormal operating conditions. The machine learning model 208 is trained to output fuel quantity measurements 210 based on the synthetic training data 214. By training the machine learning model 208 on both normal and abnormal operating conditions, the machine learning model 208 is able to recognize abnormal operating conditions and compensate for those recognized abnormal operating conditions in the fuel quantity measurements 210.

In one example, the illustrated neural network is trained by selecting a loss function (e.g., mean squared error (MSE) or mean absolute error (MAE)) for regression, selecting an iterative updater, for example using gradient descent (Adam, SGD, RMSprop, etc.), defining metrics to interpret performance of the neural network, and fitting the neural network to the synthetic training data 214 using the selected loss function and the selected iterative updater according to the defined metrics. In other examples, the machine learning model 208 can be trained using a different process. For example, the machine learning model 208 can be trained using actual flight data as training data or a combination of actual flight data and synthetic flight data.

Note that the synthetic training data 214 can be generated by the computing simulation environment program 216 in an offline process performed by the training computing system 217. Further, the machine learning model 208 can be trained in an offline training process performed by the training computing system 117. Subsequently, the trained machine learning model 208 can be sent to the computing system 114, and the computing system 114 can execute the trained machine learning model 208 to generate fuel quantity measurements 210 for the aircraft 100 in real time.

In some embodiments, the machine learning model 208 is further trained to output degradation notifications based on recognizing abnormal operating conditions. Returning to FIG. 2, in some embodiments, the machine learning model 208 is configured to output a degradation notification 224. In some examples, the degradation notification 224 indicates one or more fuel sensor probes identified by the machine learning model 208 as being degraded. In other examples, the degradation notification 224 indicates that one or more fuel tanks is contaminated and causes one or more fuel sensor probes of the plurality of fuel sensor probes to output measurements of fuel levels that are abnormal. In still other examples, the degradation notification 224 identifies other abnormal operating conditions of the aircraft 100.

Further, in some embodiments, the machine learning model 208 is configured to generate remedial actions 226 to be taken based on recognizing abnormal operating conditions. In some embodiments, the degradation notification 224 includes one or more remedial actions 226 that are to be performed to compensate for the recognized abnormal operating conditions, such as one or more fuel sensor probes being degraded. In some examples, the remedial action(s) 226 include disabling or excluding one or more fuel sensor probes identified as being degraded from being used to generate the fuel quantity measurement 210. In some examples, the remedial action(s) 226 include storing fuel quantity measurement(s) 210 and/or degradation notification(s) 224 in the maintenance log 236 on the maintenance computing system 234 so that any identified issues can be addressed by a maintenance crew in a timely manner. In other examples, the machine learning model 208 may generate other remedial actions to compensate for or resolve a recognized abnormal operating condition.

The computing system 114 is configured to output the fuel quantity measurement 210 to various systems on the aircraft 100. In one example, the fuel quantity measurement 210 is output to the display 230 of the flight deck control interface 228, so that pilots and crew of the aircraft 100 can be informed of the fuel quantity measurement 210 of the aircraft 100 and control operation of the aircraft 100 based at least on the fuel quantity measurement 210.

In some embodiments, the computing system 114 is configured to automatically adjust control of the aircraft 100 based at least on the fuel quantity measurement 210. In one example, the computing system 114 dynamically adjusts a flight plan during a flight of the aircraft 100 based at least on the fuel quantity measurement 210. For example, the computing system 114 can be configured to automatically adjust the flight plan of the aircraft 100 dynamically in mid-flight to specify that that aircraft 100 take a more direct route to a destination based at least on the fuel quantity measurement 210 indicating the fuel level is less than a low fuel threshold (or based at least on some other fuel consumption metric). As another example, the computing system 114 can be configured to automatically adjust the flight plan of the aircraft 100 dynamically in mid-flight to specify that that aircraft 100 take a more circuitous route to a destination based at least on the fuel quantity measurement 210 indicating the fuel level is greater than an upper fuel threshold. For example, the aircraft 100 could take the more circuitous route to avoid turbulent air space, such as due to a storm or other similar weather conditions. In other examples, the pilots can manually adjust the flight plan of the aircraft 100 based at least on the fuel quantity measurement 210 indicating the fuel level is less than a lower threshold or greater than an upper threshold.

In some embodiments, the computing system 114 is configured to output the fuel quantity measurement 210 to a fuel system 232 to automatically adjust a state of the fuel system 232 based at least on the fuel quantity measurement 210. For example, the fuel system 232 may be configured to automatically transfer fuel from one fuel tank to another fuel tank based at least on the fuel quantity measurement 210 indicating that one fuel tank is low on fuel or empty. In another example, the fuel system 232 may be configured to automatically transfer fuel from one fuel tank to another fuel tank based at least on the fuel quantity measurement 210 to balance the weight of fuel in different fuel tanks 102 across the aircraft 100. In other examples, the fuel system 232 can automatically perform other operations based at least on the fuel quantity measurement 210.

In some embodiments, the computing system 114 is configured to output the fuel quantity measurement 210 to the aircraft maintenance computing system 234, and the maintenance computing system 234 is configured to store the fuel quantity measurement 210 in the maintenance log 236. Fuel quantity measurements 210 generated throughout operation of the aircraft 100 can be stored in the maintenance log 236 and used as a reference to track functionality of the FQIS 101 over the operational lifespan of the aircraft 100.

In some embodiments, the computing system 114 is configured to output the degradation notification(s) 224 to various systems on the aircraft 100. In one example, the degradation notification(s) 224 is output to the display 230 of the flight deck control interface 228, so that pilots and crew of the aircraft 100 can be informed of the degradation notification(s) 224 and control operation of the aircraft 100 based at least on the degradation notification(s) 224. For example, the pilots and crew can manually perform remedial action(s) 226 recommended in the degradation notification(s) 224. In other examples, the computing system 114 is configured to automatically perform the remedial action(s) 226 to adjust operation of the aircraft 100 without human intervention.

In some embodiments, the computing system 114 is configured to output the degradation notification(s) 224 to the fuel system 232. Further, in some examples, the fuel system 232 and/or the computing system 114 are configured to automatically perform the remedial action(s) 226 to adjust operation of the aircraft 100 without human intervention. For example, the fuel system 232 and/or the computing system 114 can disable or exclude one or more fuel sensor probes identified as being degraded from being used to generate the fuel quantity measurement 210 or automatically perform other remedial actions to compensate for or correct abnormal operation of the aircraft 100.

In some embodiments, the computing system 114 is configured to output the degradation notification(s) 224 to the aircraft maintenance computing system 234 to be stored in the maintenance log 236. The degradation notification(s) 224 stored in the maintenance log 236 provide a maintenance crew with precise information about failure or degradation of components of the FQIS 101, so that the maintenance crew can appropriately address the identified issues in a timely manner with a scheduled maintenance operation.

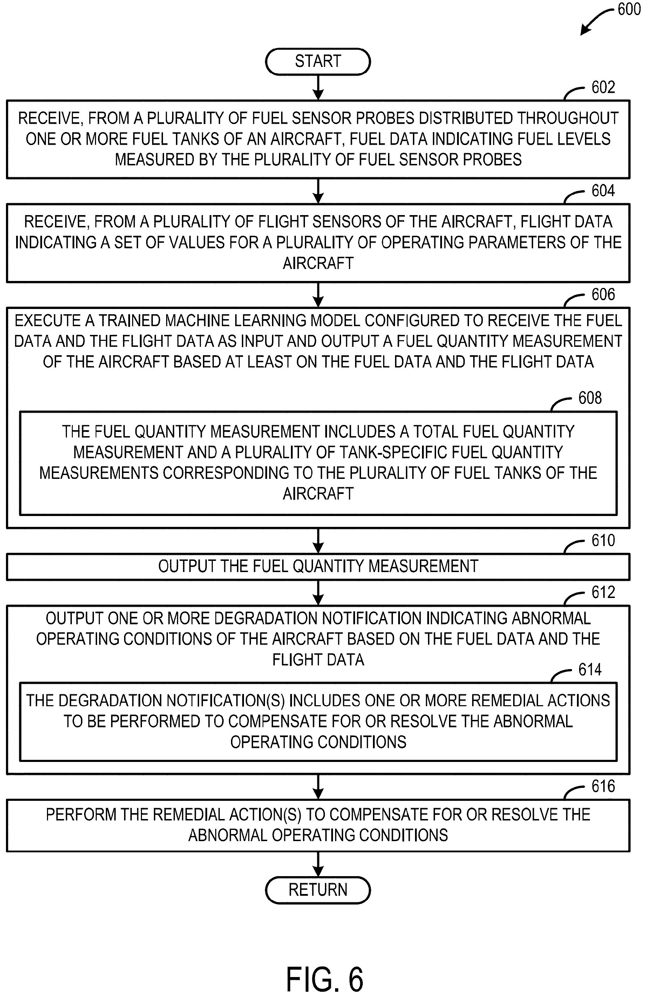

FIG. 6 shows an example computer-implemented method 600 for determining a quantity of fuel available in fuel tank(s) of an aircraft using a machine learning model, according to one embodiment of the present disclosure. For example, the method 600 can be performed by the computing system 114 shown in FIGS. 1 and 2, or by another computing system.

At 602, the method 600 includes receiving, from a plurality of fuel sensor probes distributed throughout one or more fuel tanks of an aircraft, fuel data indicating fuel levels measured by the plurality of fuel sensor probes. At 604, the method 600 includes receiving, from a plurality of flight sensors of the aircraft, flight data indicating a set of values for a plurality of operating parameters of the aircraft. At 606, the method 600 includes executing a machine learning model configured to receive the fuel data and the flight data as input and output a fuel quantity measurement of the aircraft based at least on the fuel data and the flight data. The machine learning model is trained using synthetic training data that is generated by a computer simulation environment program that is configured to model operation of the aircraft during a range of environmental conditions. The range of environmental conditions are characterized by simulation input data that indicates a set of values for a plurality of simulated operating parameters of the aircraft during the range of environmental conditions. In some embodiments where the aircraft includes a plurality of fuel tanks, at 608, the fuel quantity measurement further includes a plurality of tank-specific fuel quantity measurements corresponding to the plurality of fuel tanks of the aircraft. At 610, the method 600 includes outputting the fuel quantity measurement. For example, the fuel quantity measurement can be output to various systems of the aircraft, such as a flight deck control interface and/or a fuel system of the aircraft. In some embodiments, at 612, the method 600 includes outputting one or more degradation notifications indicating abnormal operating conditions of the aircraft based on the fuel data and the flight data. For example, the abnormal operating conditions can include a degraded / failed fuel sensor probe, contaminated fuel, a fuel tank issue (e.g., a leak), or some other abnormal operating condition. In some embodiments, at 614, the degradation notification(s) include one or more remedial actions to be performed to compensate for or resolve the abnormal operating conditions. In some embodiments, at 616, the method 600 includes performing the remedial action(s) to compensate for or resolve the abnormal operation conditions of the aircraft.

The method 600 can be performed to address the need for improved accuracy and fault tolerance in the Fuel Quantity Indication System (FQIS). By enhancing the accuracy of fuel quantity readings and making the system more resilient to failures, operation of the aircraft can be made more efficient while lowering operating costs, among other benefits. In particular, the machine learning model achieves higher accuracy in predicting fuel quantity, even in the presence of failed sensors. This enhanced accuracy allows for a reduction in allowable error during degraded operational scenarios, resulting in increased payload capacity for the aircraft. Further, the ability of the machine learning model to recognize abnormal operating conditions, ensures FQIS performance even in the event of component failures. This improves the aircraft rate of dispatch and minimizes downtime, increases operational efficiency. Further still, the use of the machine learning model to determine the fuel quantity measurement has the potential to reduce the number of components required while still maintaining the required levels of performance. This reduction in components can lead to cost savings in terms of manufacturing, maintenance, and overall system complexity.

In some embodiments, the methods and processes described herein may be tied to a computing system of one or more computing devices. In particular, such methods and processes may be implemented as a computer-application program or service, an application-programming interface (API), a library, and/or other computer-program product.

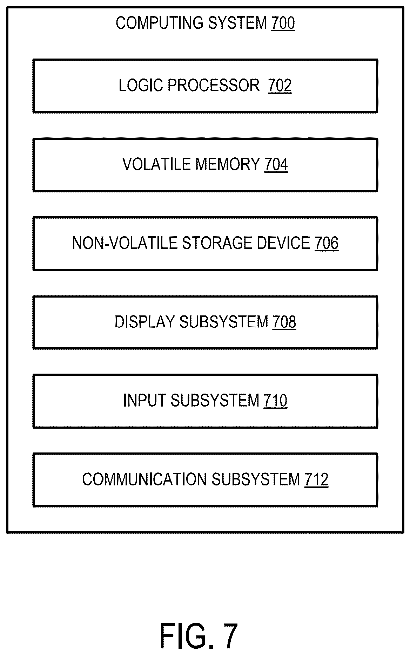

FIG. 7 schematically shows a non-limiting embodiment of a computing system 700 that can enact one or more of the methods and processes described above. Computing system 700 is shown in simplified form. Computing system 700 may embody the computing system 114 described above and shown in FIGS. 1 and 2, the training computing system 217 described above and shown in FIG. 2, and the aircraft maintenance computing system 234 described above and shown in FIG. 2. Computing system 700 may take the form of one or more personal computers, server computers, tablet computers, home-entertainment computers, network computing devices, gaming devices, mobile computing devices, mobile communication devices (e.g., smart phone), and/or other computing devices, and wearable computing devices such as smart wristwatches and head mounted augmented reality devices.

Computing system 700 includes a logic processor 702 volatile memory 704, and a non-volatile storage device 706. Computing system 700 may include a display subsystem 708, input subsystem 710, communication subsystem 712, and/or other components not shown in FIG. 7.

Logic processor 702 includes one or more physical devices configured to execute instructions. For example, the logic processor may be configured to execute instructions that are part of one or more applications, programs, routines, libraries, objects, components, data structures, or other logical constructs. Such instructions may be implemented to perform a task, implement a data type, transform the state of one or more components, achieve a technical effect, or otherwise arrive at a desired result.

The logic processor may include one or more physical processors (hardware) configured to execute software instructions. Additionally or alternatively, the logic processor may include one or more hardware logic circuits or firmware devices configured to execute hardware-implemented logic or firmware instructions. Processors of the logic processor 702 may be single-core or multi-core, and the instructions executed thereon may be configured for sequential, parallel, and/or distributed processing. Individual components of the logic processor may be distributed among two or more separate devices, which may be remotely located and/or configured for coordinated processing. Aspects of the logic processor may be virtualized and executed by remotely accessible, networked computing devices configured in a cloud-computing configuration. In such a case, these virtualized aspects are run on different physical logic processors of various different machines, it will be understood.

Non-volatile storage device 706 includes one or more physical devices configured to hold instructions executable by the logic processors to implement the methods and processes described herein. When such methods and processes are implemented, the state of non-volatile storage device 706 may be transformed, e.g., to hold different data.

Non-volatile storage device 706 may include physical devices that are removable and/or built-in. Non-volatile storage device 706 may include optical memory (e.g., CD, DVD, HD-DVD, Blu-Ray Disc, etc.), semiconductor memory (e.g., ROM, EPROM, EEPROM, FLASH memory, etc.), and/or magnetic memory (e.g., hard-disk drive, floppy-disk drive, tape drive, MRAM, etc.), or other mass storage device technology. Non-volatile storage device 706 may include nonvolatile, dynamic, static, read/write, read-only, sequential-access, location-addressable, file-addressable, and/or content-addressable devices. It will be appreciated that non-volatile storage device 706 is configured to hold instructions even when power is cut to the non-volatile storage device 706.

Volatile memory 704 may include physical devices that include random access memory. Volatile memory 704 is typically utilized by logic processor 702 to temporarily store information during processing of software instructions. It will be appreciated that volatile memory 704 typically does not continue to store instructions when power is cut to the volatile memory 704.

Aspects of logic processor 702, volatile memory 704, and non-volatile storage device 706 may be integrated together into one or more hardware-logic components. Such hardware-logic components may include field-programmable gate arrays (FPGAs), program- and application-specific integrated circuits (PASIC / ASICs), program- and application-specific standard products (PSSP / ASSPs), system-on-a-chip (SOC), and complex programmable logic devices (CPLDs), for example.

The terms "module," "program," and "engine" may be used to describe an aspect of computing system 700 typically implemented in software by a processor to perform a particular function using portions of volatile memory, which function involves transformative processing that specially configures the processor to perform the function. Thus, a module, program, or engine may be instantiated via logic processor 702 executing instructions held by non-volatile storage device 706, using portions of volatile memory 704. It will be understood that different modules, programs, and/or engines may be instantiated from the same application, service, code block, object, library, routine, API, function, etc. Likewise, the same module, program, and/or engine may be instantiated by different applications, services, code blocks, objects, routines, APIs, functions, etc. The terms "module," "program," and "engine" may encompass individual or groups of executable files, data files, libraries, drivers, scripts, database records, etc.

When included, display subsystem 708 may be used to present a visual representation of data held by non-volatile storage device 706. The visual representation may take the form of a graphical user interface (GUI). As the herein described methods and processes change the data held by the non-volatile storage device, and thus transform the state of the non-volatile storage device, the state of display subsystem 708 may likewise be transformed to visually represent changes in the underlying data. Display subsystem 708 may include one or more display devices utilizing virtually any type of technology. Such display devices may be combined with logic processor 702, volatile memory 704, and/or non-volatile storage device 706 in a shared enclosure, or such display devices may be peripheral display devices.

When included, input subsystem 710 may comprise or interface with one or more user-input devices such as a keyboard, mouse, touch screen, or game controller. In some embodiments, the input subsystem may comprise or interface with selected natural user input (NUI) componentry. Such componentry may be integrated or peripheral, and the transduction and/or processing of input actions may be handled on- or off-board. Example NUI componentry may include a microphone for speech and/or voice recognition; an infrared, color, stereoscopic, and/or depth camera for machine vision and/or gesture recognition; a head tracker, eye tracker, accelerometer, and/or gyroscope for motion detection and/or intent recognition; and/or another suitable sensor.

When included, communication subsystem 712 may be configured to communicatively couple various computing devices described herein with each other, and with other devices. Communication subsystem 712 may include wired and/or wireless communication devices compatible with one or more different communication protocols. As non-limiting examples, the communication subsystem may be configured for communication via a wireless telephone network, or a wired or wireless local- or wide-area network, such as a HDMI over Wi-Fi connection. In some embodiments, the communication subsystem may allow computing system 700 to send and/or receive messages to and/or from other devices via a network such as the Internet.

Further, the disclosure comprises configurations according to the following examples.

In an example, a computing system, comprises one or more processors, and memory holding instructions executable by the one or more processors to receive, from a plurality of fuel sensor probes distributed throughout one or more fuel tanks of an aircraft, fuel data indicating fuel levels measured by the plurality of fuel sensor probes, receive, from a plurality of flight sensors of the aircraft, flight data indicating a set of values for a plurality of operating parameters of the aircraft, execute a machine learning model configured to receive the fuel data and the flight data as input and output a fuel quantity measurement of the aircraft based at least on the fuel data and the flight data, wherein the machine learning model is trained using synthetic training data that is generated by a computer simulation environment program that is configured to model operation of the aircraft during a range of environmental conditions, and wherein the range of environmental conditions are characterized by simulation input data that indicates a set of values for a plurality of simulated operating parameters of the aircraft during the range of environmental conditions, and output the fuel quantity measurement. In this example and/or other examples, the plurality of operating parameters of the aircraft may include at least a pitch angle of the aircraft, a roll angle of the aircraft, a longitudinal axis acceleration of the aircraft, and a vertical axis acceleration of the aircraft. In this example and/or other examples, the plurality of simulated operating parameters of the aircraft may include a simulated pitch angle of the aircraft, a simulated roll angle of the aircraft, a simulated longitudinal axis acceleration of the aircraft, and a simulated vertical axis acceleration of the aircraft. In this example and/or other examples, the plurality of simulated operating parameters of the aircraft may include one or more of simulated wing deflection parameters of the aircraft, simulated electrical parameters of the aircraft, and simulated temperature conditions of the aircraft. In this example and/or other examples, the set of values for the plurality of simulated operating parameters of the aircraft indicated by the simulation input data may characterize simulated operating conditions of the aircraft in which fuel in the one or more fuel tanks is contaminated and causes one or more fuel sensor probes of the plurality of fuel sensor probes to output measurements of fuel levels that are abnormal for a designated simulated fuel quantity of the aircraft. In this example and/or other examples, the set of values for the plurality of simulated operating parameters of the aircraft indicated by the simulation input data may characterize simulated operating conditions of the aircraft in which one or more fuel sensor probes of the plurality of fuel sensor probes is degraded and outputs measurements of fuel levels that are abnormal for a designated simulated fuel quantity of the aircraft. In this example and/or other examples, the machine learning model may be configured to identify that one or more fuel sensor probes of the plurality of fuel sensor probes is degraded based at least on the fuel data and the flight data, the machine learning model may be configured to compensate for degradation of the one or more fuel sensor probes and corresponding abnormal fuel levels measurements in a calculation of the fuel quantity measurement, and the machine learning model may be configured to output a degradation notification indicating the one or more fuel sensor probes identified as being degraded. In this example and/or other examples, the degradation notification may include one or more remedial actions to be performed to compensate for the one or more fuel sensor probes being degraded. In this example and/or other examples, the one or more remedial actions may include disabling the one or more fuel sensor probes identified as being degraded from being used to generate the fuel quantity measurement. In this example and/or other examples, the aircraft may include a plurality of fuel tanks, and the fuel quantity measurement may further include a plurality of tank-specific fuel quantity measurements corresponding to the plurality of fuel tanks of the aircraft.

In another example, a computer-implemented method, comprises receiving, from a plurality of fuel sensor probes distributed throughout one or more fuel tanks of an aircraft, fuel data indicating fuel levels measured by the plurality of fuel sensor probes, receiving, from a plurality of flight sensors of the aircraft, flight data indicating a set of values for a plurality of operating parameters of the aircraft, executing a machine learning model configured to receive the fuel data and the flight data as input and output a fuel quantity measurement of the aircraft based at least on the fuel data and the flight data, wherein the machine learning model is trained using synthetic training data that is generated by a computer simulation environment program that is configured to model operation of the aircraft during a range of environmental conditions, and wherein the range of environmental conditions are characterized by simulation input data that indicates a set of values for a plurality of simulated operating parameters of the aircraft during the range of environmental conditions, and outputting the fuel quantity measurement. In this example and/or other examples, the plurality of operating parameters of the aircraft may include at least a pitch angle of the aircraft, a roll angle of the aircraft, a longitudinal axis acceleration of the aircraft, and a vertical axis acceleration of the aircraft. In this example and/or other examples, the plurality of simulated operating parameters of the aircraft may include a simulated pitch angle of the aircraft, a simulated roll angle of the aircraft, a simulated longitudinal axis acceleration of the aircraft, and a simulated vertical axis acceleration of the aircraft. In this example and/or other examples, the plurality of simulated operating parameters of the aircraft may include one or more of simulated dynamic wing deflection parameters of the aircraft, simulated electrical parameters of the aircraft, and simulated temperature conditions of the aircraft. In this example and/or other examples, the set of values for the plurality of simulated operating parameters of the aircraft indicated by the simulation input data may characterize simulated operating conditions of the aircraft in which fuel in the one or more fuel tanks is contaminated and causes one or more fuel sensor probes of the plurality of fuel sensor probes to output measurements of fuel levels that are abnormal for a designated simulated fuel quantity of the aircraft. In this example and/or other examples, the set of values for the plurality of simulated operating parameters of the aircraft indicated by the simulation input data may characterize simulated operating conditions of the aircraft in which one or more fuel sensor probes of the plurality of fuel sensor probes is degraded and outputs measurements of fuel levels that are abnormal for a designated simulated fuel quantity of the aircraft. In this example and/or other examples, the machine learning model may be configured to identify that one or more fuel sensor probes of the plurality of fuel sensor probes is degraded based at least on the fuel data and the flight data, the machine learning model may be configured to compensate for degradation of the one or more fuel sensor probes and corresponding abnormal fuel levels measurements in a calculation of the fuel quantity measurement, and the computer-implemented method may comprise outputting a degradation notification indicating the one or more fuel sensor probes identified as being degraded. In this example and/or other examples, the degradation notification may include one or more remedial actions to be performed to compensate for the one or more fuel sensor probes being degraded. In this example and/or other examples, the one or more remedial actions may include disabling the one or more fuel sensor probes identified as being degraded from being used to generate the fuel quantity measurement.

In yet another example, an aircraft, comprises one or more fuel tanks, a plurality of fuel sensor probes distributed throughout one or more fuel tanks, and a computing system comprising one or more processors and memory configured to hold instructions executable by the one or more processors to receive, from a plurality of fuel sensor probes distributed throughout one or more fuel tanks of an aircraft, fuel data indicating fuel levels measured by the plurality of fuel sensor probes, receive, from a plurality of flight sensors of the aircraft, flight data indicating a set of values for a plurality of operating parameters of the aircraft, execute a machine learning model configured to receive the fuel data and the flight data as input and output a fuel quantity measurement of the aircraft based at least on the fuel data and the flight data, wherein the machine learning model is trained using synthetic training data that is generated by a computer simulation environment program that is configured to model operation of the aircraft during a range of environmental conditions, and wherein the range of environmental conditions are characterized by simulation input data that indicates a set of values for a plurality of simulated operating parameters of the aircraft during the range of environmental conditions, and output the fuel quantity measurement.

It will be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated and/or described may be performed in the sequence illustrated and/or described, in other sequences, in parallel, or omitted. Likewise, the order of the above-described processes may be changed.

The subject matter of the present disclosure includes all novel and non-obvious combinations and sub-combinations of the various processes, systems and configurations, and other features, functions, acts, and/or properties disclosed herein, as well as any and all equivalents thereof.

Reference signs:

| | |
|---|---|
| - aircraft | 100 |
| - FQIS | 101 |
| - fuel tanks | 102 |
| - first wing | 104 |
| - fuselage | 106 |
| - second wing | 108 |
| - fuel sensor probes | 110 |
| - flight sensors | 112 |
| - computing system | 114 |
| - training computing system | 117 |
| - processors(s) | 200 |
| - memory | 202 |
| - fuel data | 204 |
| - flight data | 206 |
| - machine learning model | 208 |
| - fuel quantity measurement | 210 |
| - tank-specific fuel quantity measurements | 212 |
| - synthetic training data | 214 |
| - computer simulation environment program | 216 |
| - training computing system | 217 |
| - modeled operation | 218 |
| - environmental conditions | 220 |
| - simulation input data | 222 |
| - degradation notification | 224 |
| - remedial action(s) | 226 |
| - flight deck control interface | 228 |
| - display | 230 |
| - fuel system | 232 |
| - aircraft maintenance computing system | 234 |
| - maintenance log | 236 |
| - operating parameters | 300 |
| - pitch angle | 302 |
| - roll angle | 304 |
| - yaw angle | 306 |
| - acceleration | 308 |
| - acceleration | 310 |
| - true air speed | 312 |
| - attack | 314 |
| - temperature | 316 |
| - simulated operating parameters | 400 |
| - simulated fuel quantity | 401 |
| - simulated pitch angle | 402 |
| - simulated roll angle | 404 |
| - simulated yaw angle | 406 |
| - acceleration | 408 |
| - acceleration | 410 |
| - simulated true air speed | 412 |
| - simulated angle of attack | 414 |
| - simulated dynamic wing deflection parameters | 416 |
| - simulated electrical parameters | 418 |
| - simulated environmental conditions | 420 |
| - contaminated fuel conditions | 422 |
| - simulated degraded fuel probe conditions | 424 |
| - process | 500 |
| - input layer | 502 |
| - shared hidden layers | 504 |
| - task-specific output layer | 506 |
| - synthetic wet length measurements | 508 |
| - synthetic flight data | 510 |
| - first subset of training data | 512 |
| - second subset of training data | 514 |
| - computer-implemented method | 600 |
| - computing system | 700 |
| - logic processor | 702 |
| - volatile memory | 704 |
| - non-volatile storage device | 706 |
| - display subsystem | 708 |
| - input subsystem | 710 |
| - communication subsystem | 712 |

## Claims

1. A computer-implemented method (600), comprising:
receiving, from a plurality of fuel sensor probes (110) distributed throughout one or more fuel tanks (102) of an aircraft (100), fuel data (204) indicating fuel levels measured by the plurality of fuel sensor probes(110);
receiving, from a plurality of flight sensors (112) of the aircraft (100), flight data (206) indicating a set of values for a plurality of operating parameters (300) of the aircraft (100);
executing a machine learning model (208) configured to receive the fuel data (204) and the flight data (206) as input and output a fuel quantity measurement (210) of the aircraft (100) based at least on the fuel data (204) and the flight data (206), wherein the machine learning model (208) is trained using synthetic training data (214) that is generated by a computer simulation environment program (216) that is configured to model operation (218) of the aircraft (100) during a range of environmental conditions (220), and wherein the range of environmental conditions (220) are **characterized by** simulation input data (222) that indicates a set of values for a plurality of simulated operating parameters (400) of the aircraft (100) during the range of environmental conditions (220); and
outputting the fuel quantity measurement (210).

2. The computer-implemented method (600) of claim 1, wherein the plurality of operating parameters (300) of the aircraft (100) includes at least a pitch angle (302) of the aircraft (100), a roll angle (304) of the aircraft (100), a longitudinal axis acceleration (308) of the aircraft (100), and a vertical axis acceleration (310) of the aircraft (100).

3. The computer-implemented method (600) of claim 1, wherein the plurality of simulated operating parameters (400) of the aircraft (100) includes a simulated pitch angle (402) of the aircraft (100), a simulated roll angle (404) of the aircraft (100), a simulated longitudinal axis acceleration (408) of the aircraft (100), and a simulated vertical axis acceleration (410) of the aircraft (100).

4. The computer-implemented method (600) of claim 1, wherein the plurality of simulated operating parameters (400) of the aircraft (100) includes one or more of simulated dynamic wing deflection parameters (416) of the aircraft (100), simulated electrical parameters (418) of the aircraft (100), and simulated temperature conditions (420) of the aircraft (100).

5. The computer-implemented method (600) of claim 1, wherein the set of values for the plurality of simulated operating parameters (400) of the aircraft (100) indicated by the simulation input data (222) characterize simulated operating conditions (422) of the aircraft (100) in which fuel in the one or more fuel tanks (102) is contaminated and causes one or more fuel sensor probes (110) of the plurality of fuel sensor probes (110) to output measurements of fuel levels that are abnormal for a designated simulated fuel quantity (401) of the aircraft (100).

6. The computer-implemented method (600) of claim 1, wherein the set of values for the plurality of simulated operating parameters (400) of the aircraft (100) indicated by the simulation input data (222) characterize simulated operating conditions (424) of the aircraft in which one or more fuel sensor probes (110) of the plurality of fuel sensor probes (110) is degraded and outputs measurements of fuel levels that are abnormal for a designated simulated fuel quantity (401) of the aircraft (100).

7. The computer-implemented method (600) of claim 1, wherein the machine learning model (208) is configured to identify that one or more fuel sensor probes (110) of the plurality of fuel sensor probes (110) is degraded based at least on the fuel data (204) and the flight data (206), wherein the machine learning model (208) is configured to compensate for degradation of the one or more fuel sensor probes (110) and corresponding abnormal fuel level measurements in a calculation of the fuel quantity measurement (210), and wherein the computer-implemented method (600) comprises outputting a degradation notification (224) indicating the one or more fuel sensor probes (110) identified as being degraded.

8. The computer-implemented method (600) of claim 7, wherein the degradation notification (224) includes one or more remedial actions (226) to be performed to compensate for the one or more fuel sensor probes (110) being degraded.

9. The computer-implemented method (600) of claim 8, wherein the one or more remedial actions (226) includes disabling the one or more fuel sensor probes (110) identified as being degraded from being used to generate the fuel quantity measurement (210).

10. The computer-implemented method of any of the preceding claims, wherein:
outputting the fuel quantity measurement (210) comprises outputting the fuel quantity measurement (210) to a display 230 of a flight deck control interface (228).

11. The computer-implemented method of claim 10, further comprising:
receiving, by the one or more input interfaces of the flight deck control interface, one or more flight instructions;
controlling the aircraft according to the received one or more flight instructions.

12. The computer-implemented method according to any one of claims 1 to 9, further comprising automatically adjusting a control of the aircraft based on the fuel quantity measurement (210).

13. A computing system (114), comprising:
one or more processors (200); and
memory (202) holding instructions executable by the one or more processors (200) to execute the method according to any one of claims 1 to 9.

14. The computing system (114) of claim 10, wherein the aircraft (100) includes a plurality of fuel tanks (102), and wherein the fuel quantity measurement (210) further includes a plurality of tank-specific fuel quantity measurements (212) corresponding to the plurality of fuel tanks (102) of the aircraft (100).

15. An aircraft (100), comprising:
one or more fuel tanks (102);
a plurality of fuel sensor probes (110) distributed throughout one or more fuel tanks (102); and
a computing system (114) according to any of claims 13 and 14.
